# EUROPEAN PATENT SPECIFICATION

(11) **EP 1 613 562 B1**
(45) Date of publication and mention of the grant of the patent: **20.07.2011**
(21) Application number: 04721778.1
(22) Date of filing: 19.03.2004
(51) Int. Cl.: C03C 15/00, C03C 21/00, C03C 23/00, H01L 31/0236, H01L 31/18, C03C 17/22

(54) **GLASS TEXTURING**
TEXTURIERUNG VON GLAS
TEXTURATION DU VERRE

(30) Priority: 07.04.2003 AU 2003901559
(43) Date of publication of application: 11.01.2006
(60) Divisional application: 10186992.3
(73) Proprietor: NewSouth Innovations Pty Limited, Sydney NSW 2052 (AU)
(72) Inventor: ABERLE, Armin, Gerhard, Botany, 2019 (AU); WIDENBORG, Per, Ingemar, Clovelly, NSW 2031 (AU); CHUANGSUWANICH, Natapol, Kensington, NSW 2033 (AU)
(74) Representative: Smee, Anthony James Michael
(86) International application number: PCT/AU2004/000339
(87) International publication number: WO 2004/089841

(56) References cited:
- WO-A1-00/28602
- DE-A1- 4 318 178
- US-A- 3 951 633
- US-A- 4 042 449
- US-A- 4 885 053
- US-A- 5 376 197
- US-A- 5 399 185
- US-A1- 2003 213 770
- WIDENBORG P I ET AL: "Thick poly-Si films fabricated by the aluminium-induced crystallization bi-layer process on glass substrates" CONFERENCE RECORD OF THE 29TH IEEE PHOTOVOLTAIC SPECIALISTS CONFERENCE 20020519; 20020519 - 20020524 NEW YORK, NY : IEEE, US, vol. CONF. 29, 19 May 2002 (2002-05-19), pages 1206-1209, XP010666498 ISBN: 978-0-7803-7471-3
- WIDENBORG P ET AL: "Back electrode formation for poly-Si thin film solar cells on glass having AIC-grown seeding layer" SOLAR ENERGY MATERIALS AND SOLAR CELLS, ELSEVIER SCIENCE PUBLISHERS, AMSTERDAM, NL, vol. 74, no. 1-4, 1 October 2002 (2002-10-01), pages 305-314, XP004376956 ISSN: 0927-0248
- WIDENBORG P I ET AL: "Surface morphology of poly-Si films made by aluminium-induced crystallisation on glass substrates" JOURNAL OF CRYSTAL GROWTH, ELSEVIER, AMSTERDAM, NL, vol. 242, no. 3-4, 1 July 2002 (2002-07-01), pages 270-282, XP004368857 ISSN: 0022-0248

## Description

### Tchnical field

The present invention relates broadly to a method of texturing a glass surface, to a method of manufacturing a photovoltaic device, to a textured glass surface, and to a photovoltaic device.

### Background

Textured glass surfaces are useful for a number of applications, including in photovoltaic devices or for applications in which it is desired to scatter light rays such that objects are no longer clearly visible through the glass.

In photovoltaic devices, light trapping is used to trap light in the active region of the device. The more light is trapped in the device the higher the light-generated photocurrent, and consequently the higher the energy conversion efficiency of the device. Therefore, light trapping is an important issue when trying to improve the conversion efficiency of photovoltaic devices and is particularly important in thin-film devices. Because most photovoltaic devices involve a glass pane, light trapping in these devices can be realised by texturing the glass pane.

Conventionally, chemical texturing or sand blasting are used for texturing glass panes. Alternative approaches have recently been disclosed for preparing textured glass surfaces. One of those approaches uses metal crystal deposits on a glass surface to form very fine crystals and thereby producing the glass texture effect. Another approach uses a liquid surface coating ("sol-gel") containing SiO₂ spheres that, after densification, produces a textured glass surface.

However, these methods have specific disadvantages for photovoltaic device applications. Both chemical texturing and sand blasting can cause cracks and nonuniform feature size on the glass surface, which can adversely affect photovoltaic device fabrication and/or performance (for instance by causing electrical shunts in the devices). On the other hand, the use of fine metal crystals for making a textured glass surface appears to be quite an expensive method. Finally, it appears to be difficult to scale up the sol-gel method to very large dimensions (∼1m²) as required for photovoltaic panels.

A need, therefore, exists to provide an alternative method for texturing a glass surface which addresses one or more of these disadvantages.

### Disclosure of the Invention

US-A-3951633 discloses a method for patterning or texturing the surface of glass manufactured by a float process and comprises depositing particulate carbon onto the surface of a continuous ribbon of heat softened glass, which is being drawn across a molten metal bar. The deposited carbon attacks the surface of the glass to thereby produce a patterned or textured finish thereon.

WIDENBORG P I EL AL: "Thick poly-Si films fabricated by the aluminium induced crystallization bi-layer process on glass substrates" CONFERENCE RECORD OF THE 29TH IEEE PHOTOVOLTAIC SPECIALISTS CONFERENCE 20020519; 20020519 - 20020524 NEW YORK, NY: IEEE, US, vol. CONF. 29, 19 May 2002 (2002-05-19), pages 1206-1209, XP010666498 ISBN: 978-0-7803-7471-3 discloses a poly-silicon thin film on a glass substrate manufactured via an aluminium induced crystallization bi-layer process of amorphous silicon.

WIDENBORG P ET AL: "Back electrode formation for poly-Si thin film solar cells on glass having AIC-grown seeding layer" SOLAR ENERGY MATERIALS AND SOLAR CELLS, ELSEVIER SCIENCE PUBLISHERS, AMSTERDAM, NL, vol. 74, no. 1-4, 1 October 2002 (2002-10-01), pages 305-314, XP004376956 ISSN: 0927-0248 discloses the definition of various conductive materials including aluminium onto a glass substrate by aluminium induced crystallization by way of vacuum evaporation of aluminium onto glass followed by sputter deposition of amorphous silicon.

WIDENBORG P I ET AL: "Surface morphology of poly-Si films made by aluminium-induced crystallisation on glass substrates" JOURNAL OF CRYSTAL GROWTH, ELSEVIER, AMSTERDAM, NL, vol. 242, no. 3-4, 1 July 2002 (202-07-01), pages 270-282, XP004368857 ISSN: 0022-0248 discloses the formation of polycrystalline silicone films made at temperature of approximately 500°C by aluminium induced crystallisation bi-layer process on the glass substrates.

In accordance with a first aspect of the present invention there is provided a method of texturing a glass surface, the method comprising the steps of:
- coating the glass surface with an aluminium film,
- stimulating a reaction at the interface between the glass and the material film resulting in the formation of reaction products at the interface, and
- removing the material film and the reaction products from the glass surface;
wherein the step of stimulating the reaction at the interface comprises a thermal annealing process; characterised in that
the thermal annealing process comprises a sequence of annealing steps at different temperatures.

The thermal annealing process may be conducted in a controlled ambient atmosphere.

The material film may comprise a single material or compound material.

The glass surface may initially be substantially flat.

The material film in one embodiment comprise aluminium. The reaction products may comprise aluminium oxide.

The step of removing the material film and the reaction products may comprise one or more etching steps.

The glass may comprise quartz, floating glass, or non-float glass.

In accordance with a second aspect of the present invention there is provided a method of manufacturing a photovoltaic device, the method comprises the steps of texturing a glass surface utilising the method as defined in the first aspect, and depositing a semiconductor film on the textured glass surface, whereby the glass-facing surface of the semiconductor film exhibits substantially the same degree of texture as the glass surface.

In one embodiment, the semiconductor film is deposited in a manner such that substantially no gaps or voids exist between the textured glass surface and the semiconductor film.

The method may further comprise forming a dielectric barrier layer between the glass surface and the semiconductor. The dielectric layer may be formed on the textured glass surface prior to the deposition of the semiconductor film. The dielectric barrier layer may comprise silicon oxide or silicon nitride.

The semiconductor film may comprise a crystalline and/or an amorphous semiconductor material. The semiconductor material may comprise silicon.

In accordance with a third aspect of the present invention there is provided a textured glass surface formed utilising the method as defined in the first aspect.

In accordance with a fourth aspect of the present invention there is provided a photovoltaic device manufactured utilising the method as defined in the second aspect.

In accordance with a fourth aspect of the present invention there is provided a photovoltaic device comprising a glass pane having a textured surface a semiconductor film formed on the textured surface of the glass pane and having an internal absorption efficiency greater than about 0.5 for photons in a wavelength range from about 600 to 1200 nm.

### Brief description of the drawings

Preferred embodiments of the invention will now be described, by way of example, with reference to the accompanying drawings in which:
Figures 1 to 4 are schematic drawings illustrating a method of texturing the surface of a glass pane, embodying the present invention.
Figure 5 shows a FIB (focused ion beam) microscopical photograph of the top surface of a silicon-coated textured glass pane, embodying the present invention.
Figure 6 shows a FIB microscopical photograph of a different region of the sample of Figure 5.
Figure 7 shows the measured light trapping properties of the sample of Figure 5, compared with prior art samples.

### Detailed description and best mode

The embodiments described provide methods of texturing a glass surface suitable for use in the manufacturing of thin-film semiconductor photovoltaic devices.

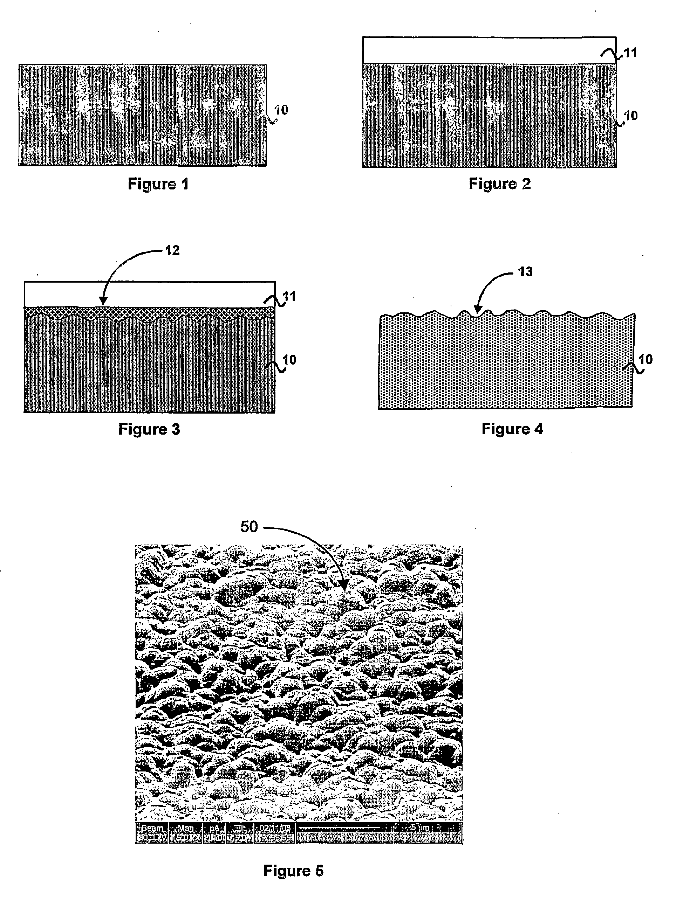

Figures 1 to 4 are schematic drawings illustrating a method of texturing the surface of a glass pane 10, embodying the present invention. Figure 1 shows the glass pane 10, having a substantially flat upper surface and being a borosilicate glass in an example embodiment.

In a first step shown in Figure 2, the glass pane 10 is coated with an aluminium film 11 utilising, in the example embodiment, thermal vacuum evaporation at about 10⁻⁵ Torr. In the example embodiment, the initial aluminium coating 11 is of a thickness of about 500 nm.

Next, the Al-coated glass pane is thermally annealed at elevated temperature, in the example embodiment in a two-step process with about 120 mins at about 500°C, followed by about 360 mins at about 620°C in a nitrogen atmosphere.

In another embodiment, a three-step process with about 120 mins at about 500°C, followed by about 180 mins at about 560°C, followed by about 180 mins at about 630°C in a nitrogen atmosphere may be applied.

It has been found by the applicants that the A1 reacts spatially non-uniformly with the glass pane, forming reaction products in the form of mixtures (12 in Figure 3) of aluminium oxide and silicon. A subsequent removal of both the A1 film 11 and the reaction products 12 forms a textured glass surface as schematically shown in Figure 4. In the example embodiment, a 2-step chemical etch with about 10 mins in 85% phosphoric acid solution at about 110°C, followed by about 20 to about 45 secs in a 1:1HF/HNO₃ solution at room temperature was used to remove the reaction products 12 and aluminium film 11.

In another embodiment, a 2-step chemical etch with about 10 mins in phosphoric acid at about 110°C, followed by a second etch in a HF/HNO₃ solution at room temperature where the HF/HNO₃ ratio is in the range from about 1:1 to 1:20 is applied. Depending on the ratio used, a short ultrasonic waterbath treatment may be utilised after the second etching step to completely remove all reaction products.

It is noted here, that, depending on the type of removal technique, for example the type of etching solution, used, some amount of glass that has not reacted with the coating can also be removed, if desired.

Dimples (13 in Figure 4) in the glass pane result from the removal of the Al/glass reaction products 12. The average size of the dimples can be adjusted over a wide range (from less than 1 µm to up to 10 µm) by e.g. selecting a suitable thermal annealing profile and/or a suitable removal technique for the Al/glass reaction products 12. This dimple size is well suited for thin-film photovoltaic applications because in those devices the semiconductor film thickness is typically in the range 0.5 - 3 µm.

In the example embodiment, the method textures the glass in such a way that there are no "overhanging" regions, i.e. when the textured glass pane 10 of Fig. 4 was illuminated by parallel light from above, there were no shaded regions within the dimples of the surface texture. This feature is advantageous for device applications, for instance if the subsequently formed semiconductor film needs to be in intimate contact with the glass everywhere (i.e., there must be no voids or gaps between the glass and the semiconductor film).

Another advantageous feature of textured glass samples embodying the present invention is that their transmission for light is only very weakly reduced by the texture.

Figure 5 shows a FIB microscopical photograph of the top surface 50 of a silicon-coated textured glass pane fabricated using a method embodying the present invention. The silicon film is of polycrystalline nature and has a thickness of about 1.5 µm (i.e., similar to the dimensions of the texture features). It was created by thermal annealing ("solid-phase crystallisation") of a plasma enhanced chemical vapour deposition (PECVD)-deposited amorphous silicon film. The striking feature of the surface 50 of the silicon coated glass pane is its cauliflower-like nature, caused by the textured glass surface [note that the silicon film has a planar, smooth top surface if fabricated on a non-textured (i.e., planar) glass pane]. The cauliflower-like top surface 50 of the silicon film is an indicator for good light trapping characteristics.

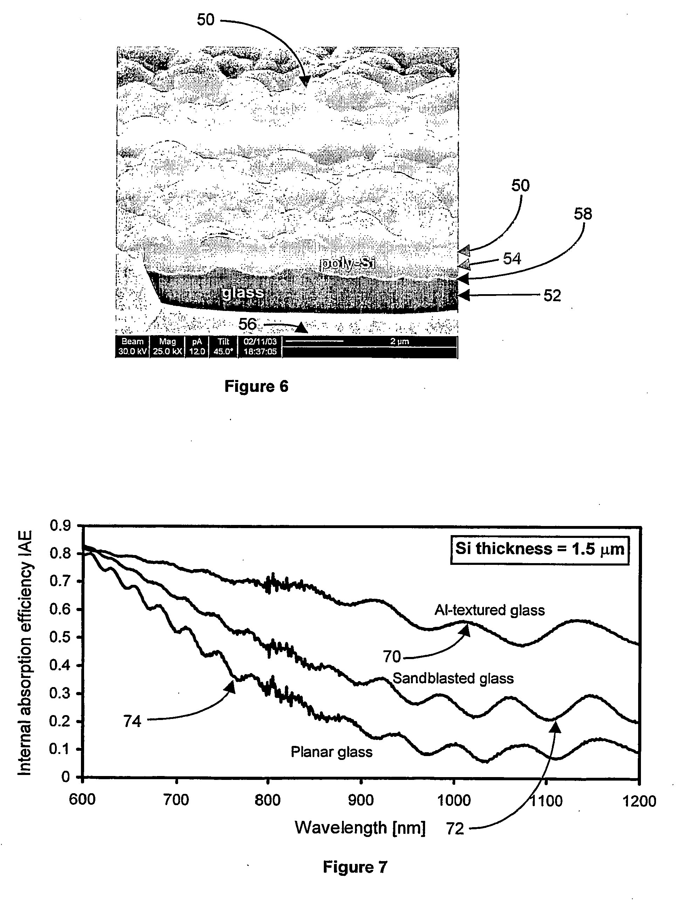

Figure 6 shows a FIB microscopical photograph of a different region of the same sample, whereby additionally a trench was milled (using gallium ions) into the sample surface to reveal the cross-sectional properties of both the textured glass pane 52 and the polycrystalline silicon film 54 subsequently formed on the surface of the textured glass pane 52. The lateral marker 56 in Fig. 6 represents 2 µm. It can be seen that the poly-Si film 54 is everywhere in intimate contact with the surface of the textured glass pane 52 and that there are no voids or gaps between the glass pane 52 and the poly-Si film 54. This is advantageous for many device applications due to issues such as adhesion of the semiconductor film to the glass, long-term stability of the device, etc..

Another feature visible in Figure 6, advantageous for good light trapping in thin-film photovoltaic devices, is the fact that in most regions of the sample the "top" and "bottom" surfaces 50 and 58 respectively of the poly-Si film 54 are sufficiently non-parallel, leading to the trapping of light due to the phenomenon of total internal reflection. However, it is noted that even if the two surfaces 50, 58 are substantially parallel, i.e. if the texture of the glass-facing surface 58 of the poly-Si film 54 is "directly transferred", resulting in a corresponding texture on the surface 50 facing away from the glass 52, useful light trapping characteristics can still be achieved.

The light trapping can be further improved in actual devices by incorporating a back-surface reflector (BSR) (not shown) for near-infrared photons. The BSR can, for instance, be a silver or aluminium film. The BSR is either deposited onto the semiconductor film (if the sunlight enters the semiconductor through the glass) or onto the non-textured glass surface (if the semiconductor-coated, textured side of the glass faces the sun).

Figure 7 shows that excellent light trapping is realised in thin (∼1.5 micron) polycrystalline silicon films formed on glass panes textured according to the described embodiment. The curve 70 labelled "Al-textured glass" was measured on the sample of Figure 5. The plotted parameter is the measured internal absorption efficiency (IAE) which, for each wavelength, describes which fraction of those photons that entered the Si film is absorbed within the Si film. The higher the IAE the better the light trapping.

Also shown, for comparison, is the measured IAE of a 1.5-µm thick poly-Si film on a planar glass pane (curve 74) and on a sandblasted glass pane (curve 72). Clearly, the Al-textured glass provides by far the best light trapping of the three investigated structures. Note that the samples did not have a back surface reflector (BSR) during these optical measurements and hence the IAE of actual devices (such as thin-film photovoltaics) can be further improved by adding a suitable BSR.

It is further noted that glass panes textured in accordance with the described embodiment efficiently scatter light rays that pass through the glass panes, making them useful for other applications outside their use for photovoltaic devices. One such application is e.g. as glass panes for scattering windows or screens.

It will be appreciated by the person skilled in the art that numerous modifications and/or variations may be made to the present invention as shown in the specific embodiments without departing from the spirit or scope of the invention as broadly described. The present embodiments are, therefore, to be considered in all respects to be illustrative and not restrictive.

For example, it will be appreciated that the present invention is not limited to the dimensions and/or thin-film deposition techniques and/or reaction products removal techniques of the example embodiments described.

Furthermore, while in the embodiments described the glass texturing processes were optimised for borosilicate glass, it will be appreciated that the processing can be chosen and optimised for different glasses, including soda-lime glass, which is often used as a cheap window glass.

## Claims

1. A method of texturing a glass surface (50), the method comprising the steps of:
- coating the glass surface with a material film (11),
- stimulating a reaction at the interface between the glass (50) and the material film (11) resulting in the formation of reaction products at the interface, and
- removing the material film (11) and the reaction products (12) from the glass surface;
wherein the step of stimulating the reaction at the interface comprises a thermal annealing process; **characterised in that**
the thermal annealing process comprises a sequence of annealing steps at different temperatures.

2. The method as claimed in claim 1, wherein the thermal annealing process is conducted in a controlled ambient atmosphere.

3. The method as claimed in any one of the preceding claims, wherein the material film comprises a single material or compound material.

4. The method as claimed in any one of the preceding claims, wherein the glass surface is initially substantially flat.

5. The method as claimed in any of the preceding claims, wherein the material film (14) comprises aluminium.

6. The method as claimed in claim 5, wherein the reaction products (12) comprise aluminium oxide and/or silicon.

7. The method as claimed in any one of the preceding claims, wherein the step of removing the material film (11) and the reaction products (12) comprises one or more etching steps.

8. The method of claim 7, wherein the etching steps comprise a chemical etch.

9. The method as claimed in any one of the preceding claims, wherein the glass comprises quartz, float glass, or non-float glass.

10. A method of manufacturing a photovoltaic device, the method comprises the steps of texturing a glass surface (50) utilising a method as claimed in any one of the preceding claims, and depositing a semiconductor film on the textured glass surface, whereby the glass-facing surface of the semiconductor film exhibits substantially the same degree of texture as the glass surface.

11. The method as claimed in claim 10, wherein the semiconductor film is deposited in a manner such that substantially no gaps or voids exist between the textured glass surface and the semiconductor film.

12. The method as claimed in claims 10 or 11, wherein the method further comprises forming a dielectric barrier layer between the glass and the semiconductor.

13. The method as claimed in claim 12, wherein the dielectric layer is formed on the textured glass surface (50) prior to the deposition of the semiconductor film.

14. The method as claimed in claims 12 or 13, wherein the barrier layer comprises silicon oxide or silicon nitride.

15. The method as claimed in any one of claims 10 to 14, wherein the semiconductor film comprises a crystalline and/or an amorphous semiconductor material.

16. The method as claimed in claim 15, wherein the semiconductor material comprises silicon.

17. A glass pane (10) having a textured surface (50) formed utilising a method as claimed in any one of claims 1 to 9.

18. A photovoltaic device manufactured utilising a method in any one of claims 10 to 16.

19. A photovoltaic device comprising:
a glass pane (10) having a textured surface (50) according to claim 17;
a semiconductor film formed on the textured surface of the glass pane and having an internal absorption efficiency greater than about 0.5 for photons in a wavelength range from about 600 to 1200 nm.

## Patentansprüche

1. Verfahren zum Texturieren einer Glasoberfläche (50), wobei das Verfahren folgende Schritte umfasst:
- Beschichten der Glasoberfläche mit einem Materialfilm (11),
- Anregen einer Reaktion an der Grenzfläche zwischen dem Glas (50) und dem Materialfilm (11), die in der Bildung von Reaktionsprodukten an der Grenzfläche resultiert, und
- Entfernen des Materialfilms (11) und der Reaktionsprodukte (12) von der Glasoberfläche;
wobei der Schritt des Anregens der Reaktion an der Grenzfläche einen Temperprozess umfasst, **dadurch gekennzeichnet, dass**
der Temperprozess eine Folge von Temperschritten bei verschiedenen Temperaturen umfasst.

2. Verfahren nach Anspruch 1, wobei der Temperprozess in einer kontrollierten Umgebungsatmosphäre ausgeführt wird.

3. Verfahren nach einem der vorangehenden Ansprüche, wobei der Materialfilm ein einziges Material oder zusammengesetztes Material umfasst.

4. Verfahren nach einem der vorangehenden Ansprüche, wobei die Glasoberfläche anfänglich im Wesentlichen eben ist.

5. Verfahren nach einem der vorangehenden Ansprüche, wobei der Materialfilm (14) Aluminium umfasst.

6. Verfahren nach Anspruch 5, wobei die Reaktionsprodukte (12) Aluminiumoxid und/oder Silizium umfassen.

7. Verfahren nach einem der vorangehenden Ansprüche, wobei der Schritt des Entfernens des Materialfilms (11) und der Reaktionsprodukte (12) einen oder mehrere Ätzschritte umfasst.

8. Verfahren nach Anspruch 7, wobei die Ätzschritte ein chemisches Ätzen umfassen.

9. Verfahren nach einem der vorangehenden Ansprüche, wobei das Glas Quarz, Floatglas oder Nicht-Floatglas umfasst.

10. Verfahren zum Herstellen einer Photovoltaikvorrichtung, wobei das Verfahren die Schritte des Texturierens einer Glasoberfläche (50) unter Nutzung eines Verfahrens nach einem der vorangehenden Ansprüche und das Abscheiden eines Halbleiterfilms auf der texturierten Glasoberfläche umfasst, wobei die dem Glas zugewandte Oberfläche des Halbleiterfilms im Wesentlichen den selben Grad an Textur aufweist, wie die Glasoberfläche.

11. Verfahren nach Anspruch 10, wobei der Halbleiterfilm auf eine derartige Weise abgeschieden wird, dass im Wesentlichen keine Lücken oder Hohlräume zwischen der texturierten Glasoberfläche und dem Halbleiterfilm existieren.

12. Verfahren nach Anspruch 10 oder 11, wobei das Verfahren weiter das Bilden einer dielektrischen Sperrschicht zwischen dem Glas und dem Halbleiter umfasst.

13. Verfahren nach Anspruch 12, wobei die dielektrische Schicht vor dem Abscheiden des Halbleiterfilms auf der texturierten Glasoberfläche (50) gebildet wird.

14. Verfahren nach Anspruch 12 oder 13, wobei die Sperrschicht Siliziumoxid oder Siliziumnitrid umfasst.

15. Verfahren nach einem er Ansprüche 10 bis 14, wobei der Halbleiterfilm ein kristallines und/oder ein amorphes Halbleitermaterial umfasst.

16. Verfahren nach Anspruch 15, wobei das Halbleitermaterial Silizium umfasst.

17. Glasscheibe (10) mit einer texturierten Oberfläche (50), die unter Nutzung eines Verfahrens nach einem der Ansprüche 1 bis 9 gebildet wird.

18. Photovoltaikvorrichtung, die unter Nutzung eines Verfahrens nach einem der Ansprüche 10 bis 16 hergestellt wird.

19. Photovoltaikvorrichtung, die Folgendes umfasst:
eine Glasscheibe (10) mit einer texturierten Oberfläche (50) nach Anspruch 17;
einen Halbleiterfilm, der auf der texturierten Oberfläche der Glasscheibe gebildet ist und eine innere Absorptionseffizienz von größer als ungefähr 0,5 für Photonen in einem Wellenlängenbereich von ungefähr 600 bis 1200 nm aufweist.

## Revendications

1. Procédé pour texturer une surface de verre (50), ce procédé comprenant les étapes consistant à :
- revêtir la surface de verre d'un film de matériau (11),
- stimuler une réaction à l'interface entre le verre (50) et le film de matériau (11) résultant en la formation de produits de réaction à l'interface, et à
- enlever le film de matériau (11) et les produits de réaction (12) de la surface du verre ;
dans lequel l'étape consistant à stimuler la réaction à l'interface comprend un procédé de recuisson thermique ; **caractérisé en ce que**
ce procédé de recuisson thermique comprend une séquence d'étapes de recuisson à différentes températures.

2. Procédé selon la revendication 1, dans lequel le procédé de recuisson thermique est effectué dans une atmosphère ambiante contrôlée.

3. Procédé selon l'une quelconque des revendications précédentes, dans lequel le film de matériau comprend un matériau simple ou un matériau composite.

4. Procédé selon l'une quelconque des revendications précédentes, dans lequel la surface du verre est essentiellement plate.

5. Procédé selon l'une quelconque des revendications précédentes, dans lequel le film de matériau (14) comprend de l'aluminium.

6. Procédé selon la revendication 5, dans lequel les produits de réaction (12) comprennent de l'oxyde d'aluminium et/ou du silicium.

7. Procédé selon l'une quelconque des revendications précédentes, dans lequel l'étape consistant à enlever le film de matériau (11) et les produits de réaction (12) comprend une ou plusieurs étapes de gravure.

8. Procédé selon la revendication 7, dans lequel les étapes de gravure comprennent une gravure chimique.

9. Procédé selon l'une quelconque des revendications précédentes, dans lequel le verre comprend du quartz, du verre flotté, ou du verre non flotté.

10. Procédé de fabrication d'un dispositif photovoltaïque, ce procédé comprenant les étapes consistant à texturer une surface de verre (50) en utilisant un procédé selon l'une quelconque des revendications précédentes, et à déposer un film semi-conducteur sur la surface de verre texturée, ce qui fait que la surface du film semi-conducteur tournée vers le verre présente essentiellement le même degré de texture que la surface du verre.

11. Procédé selon la revendication 10, dans lequel le film semi-conducteur est déposé de manière à ce qu'essentiellement aucun espace ou aucun vide n'existe entre la surface de verre texturée et le film semi-conducteur.

12. Procédé selon les revendications 10 ou 11, ce procédé comprenant en outre la formation d'une couche d'arrêt diélectrique entre le verre et le semi-conducteur.

13. Procédé selon la revendication 12, dans lequel la couche diélectrique est formée sur la surface de verre texturée (50) avant le dépôt du film semi-conducteur.

14. Procédé selon les revendications 12 ou 13, dans lequel la couche d'arrêt comprend de l'oxyde de silicium ou du nitrure de silicium.

15. Procédé selon l'une quelconque des revendications 10 à 14, dans lequel le film semi-conducteur comprend un matériau semi-conducteur cristallin et/ou un matériau semi-conducteur amorphe.

16. Procédé selon la revendication 15, dans lequel le matériau semi-conducteur comprend du silicium.

17. Carreau de verre (10) ayant une surface texturée (50) formée en utilisant un procédé selon l'une quelconque des revendications 1 à 9.

18. Dispositif photovoltaïque fabriqué en utilisant un procédé selon l'une quelconque des revendications 10 à 16.

19. Dispositif photovoltaïque comprenant :
un carreau de verre (10) ayant une surface texturée (50) selon la revendication 17 ;
un film semi-conducteur formé sur la surface texturée du carreau de verre et ayant une efficacité d'absorption interne supérieure à environ 0,5 pour des photons dans une gamme de longueurs d'onde située entre environ 600 et 1200 nm.
